Europäisches Patentamt

European Patent Office

Office européen des brevets

(11) Publication number: **0 306 974**
**A2**

(12) # EUROPEAN PATENT APPLICATION

(21) Application number: 88114784.7

(22) Date of filing: 09.09.88

(51) Int. Cl.⁴: **C04B 35/00 , C04B 35/64 , C01G 1/00 , H01L 39/24**

Claims for the following Contracting State: ES.

(30) Priority: **11.09.87 US 95084**

(43) Date of publication of application:
**15.03.89 Bulletin 89/11**

(84) Designated Contracting States:
**AT BE CH DE ES FR GB GR IT LI LU NL SE**

(71) Applicant: **W.R. Grace & Co.-Conn. (a Connecticut corp.)**
**Grace Plaza 1114 Avenue of the Americas New York New York 10036(US)**

(72) Inventor: **Spencer, Nicholas David**
**5311 42nd St., N.W.**
**Washington District of Columbia 20015(US)**
Inventor: **Cheng, Wu-Cheng**
**10325 Whitewasher Way**
**Columbia Maryland 21044(US)**

(74) Representative: **Abitz, Walter, Dr.-Ing. et al**
**Abitz, Morf, Gritschneder, Freiherr von Wittgenstein Postfach 86 01 09**
**D-8000 München 86(DE)**

(54) **Method for manufacture of high-temperature superconducting materials.**

(57) Superior homogeneity in ceramic compositions is achieved by spray drying solutions of L.M.A. salts, suitably nitrates, where L is at least one metal of the rare earth groups including scandium and yttrium; M is Be, Mg, Ca, Sr, or Ba; and A is Cu, Ag, or Au. The spray dried particles are calcined (e.g., to $Y.Ba_2.Cu_3$ oxides), to provide superconducting metal oxide ceramic compositions.

EP 0 306 974 A2

# METHOD FOR MANUFACTURE OF HIGH-TEMPERATURE SUPERCONDUCTING MATERIALS

## RELATED APPLICATION

U.S.S.N. 095,083 , filed Sept.11,1987, Spencer, Pan, and Rudesill, discloses and claims L.M.A. carbonates adapted to the preparation of superconductors [Docket 7129].

## FIELD OF THE INVENTION

This invention relates to the preparation of superconducting ceramics and more particularly to an improvement in preparing the metal oxide system generically represented by L.M.A.D. where (e.g.) L may be yttrium; M may be barium; A, copper; and D, oxygen.

## BACKGROUND OF THE INVENTION

It has long been known that the effective resistivity of certain metals was sometimes substantially eliminated, when the metal was exposed to low temperature conditions. Of particular interest were the metals and metal oxides which can conduct electricity under certain low temperature conditions with virtually no resistance. These have become known as superconductors. Certain metals, for example, are known to be superconductive when cooled to about $4^\circ$ on the Kelvin scale ($^\circ$K), and certain niobium alloys are known to be superconductive at about $15^\circ$ K, some as high as about $23^\circ$ K. More recently, an oxide containing lanthanum, barium, and copper was discovered which became superconductive at temperatures of about $30^\circ$ K, and in some circumstances, at temperatures of about 20 degrees higher. Current advances have identified materials which become superconductive at temperatures near $100^\circ$ K, such that liquid nitrogen cooling could be used. Of special interest are ceramic materials which have reduced electrical resistance properties that are stable over time such that they could be developed for use in practical applications. While the phenomena of reduced electrical resistance and even superconductivity has now been observed at liquid nitrogen temperatures or above, these properties are still considered to be achieved primarily at low temperatures when compared to ambient conditions. However, there is some indication that ceramic materials might be formulated which can reliably exhibit reduced electrical resistance and perhaps superconductivity at ambient conditions.

A composition having an approximate unit cell formula of $Y.Ba_2.Cu_3.O_z$, where z is typically about 7, and various related materials, represents a particularly promising group of ceramics for superconducting applications. The compositions are typically formulated from precursors which can be mixed to provide the desired ceramic. In one formulation for these ceramic materials, for example, carbonate and/or oxide powders of the solid elements are mixed and raised to a temperature of about $1,000^\circ$ C, driving off volatile materials, such as carbon dioxide. The mixture is reground and reheated, ordinarily several times to improve the intimacy of the mixture, and then can be pelletized, sintered for several hours, and then gradually cooled to below $250^\circ$ C.

Pellets have proven convenient for research applications properly involving ceramic superconductive materials since they can be readily formed by pressing together the powdered materials and binding them by a sintering process. These ceramic materials are typically brittle such that they are also more readily handled in pellet form. However, commercial applications of superconductors are likely to require substantial quantities of such materials in useful shapes such as tubes, rods, wires, or sheets, and other techniques for conveniently and reliably shaping these ceramic materials while maintaining their ability to conduct electricity with reduced resistance are being sought.

Reportedly, one procedure has been developed in which the ceramic powder is encased in a thin tube of metal such as silver, and then drawing the filled tube to form a wire. Evaporative techniques have also been reportedly used to produce films of superconducting materials from multiphase material comprising yttrium, barium, copper, and oxygen. In still another procedure, the ceramic powder, or even its ingredients, are mixed into an organic binder such as polyethylene glycol which is then extruded to form a plastic wire. After the wire is formed into the desired shape, the binder is burnt off and the residual powders are sintered to form the product filament. Tapes have also been produced by embedding ceramic particles in organic material to produce a flexible tape which can be shaped and then sintered. The conductive performance of the final ceramic material is known to be dependent upon the uniformity of element distribution throughout the composition. A common objective in any of the techniques for formulating and processing superconductive materials is to assure intimate mixing of precursor materials to provide a relatively homogeneous ceramic product.

Mention may be made of certain references in the literature.

Wu et al, Superconductivity at 93K in a New Mixed Phase Y-Ba-Cu-O Compound System at Ambient Pressure, Physical Review Letters, 58, 908-910 (2 March 1987) discloses making the title compounds by solid state reaction of $Y_2O_3$, $BaCO_3$, and CuO.

Engler et al, Superconductivity above Liquid Nitrogen Temperature: Preparation and Properties of a Family of Perovskite-Based Superconductors, J. Am. Chem. Soc. 109, 2848-2849 (1987), mixes $Y_2O_3$, $BaCO_3$, and CuO in a ball mill to give a 1:2:3 ratio of Y, Ba, Cu. The powder was heated in an alumina boat at 950°C, and the resulting black powder was reground and heated again.

Wang et al, Comparison of Carbonate, Citrate, and Oxalate Chemical Routes to the High-$T_c$ Metal Oxide Superconductors $La_{2-x}Sr_xCuO_4$, Inorg. Chem. 26, 1474-1476 (1987).

## SUMMARY OF THE INVENTION

The crux of our invention is spray-drying solutions of L.M.A. salts. This process provides L.M.A. particles, generally spherical or spheroidal, of remarkable homogeneity as to composition. That is to say, the initial L.M.A. ratio, as prepared in solution, is carried through in substantially every particle of the spray-dried product and so into the calcined product and into the ultimate superconductor.

Following convention, by L is meant the rare earth group, i.e., elements with atomic numbers 57-71 inclusive, plus scandium and yttrium. By M is meant Ba, Be, Mg, Ca, and Sr. By A is meant Cu, Ag, and Au.

## DETAILED DESCRIPTION OF THE INVENTION

Superconducting ceramic solids consist essentially of metal oxides and are formulated in accordance with this invention by dissolving in a solvent which vaporizes without leaving substantial residue, soluble precursors of the ceramic solid which, upon firing in an oxygen-containing atmosphere, yield the metal oxide; spray drying the solution of metal compounds, thereby obtaining an intimate blend of the metals; and firing the composition in an oxygen-containing environment to produce the desired ceramic material. Precursors include compounds of the metals of the ceramic, for example, the metal nitrates, which can be combined under heated conditions to form the desired ceramic. A particularly effective demonstration of superconductivity is that the product will levitate a magnet, as hereinafter described. Superconductivity may not be exhibited under all temperature conditions, but may instead be exhibited only within certain temperature ranges. The most preferred superconductive materials exhibit superconductivity at the temperatures of liquid nitrogen (about 77°K) or below, where practical applications may more readily be practiced. It is noted that the technology of superconductive materials is rapidly developing, and that it would no longer be surprising if metal oxide ceramic materials, which are reliably superconductive at room temperature or above, were identified. It is considered that this invention will as well apply to fabricating solids from particles of such materials.

The solvents of this invention are those which vaporize without leaving substantial residue which can interfere with the electrically conductive nature of the ceramic product. Spray drying is intended to vaporize the solvent to a large extent, but it is recognized that some solvent is adsorbed or otherwise incorporated into the spray dried blend. Therefore, the preferred solvents are those which, even if present in the spray dried blend, will thereafter volatilize during the firing procedure. Examples of these preferred solvents include deionized water, and ethanol and other lower alkanols. Deionized water is the most preferred of the solvents. It is the cheapest and the safest.

The precursors also must be chosen such that they yield, upon firing, the desired ceramic material. (See "Metal Salt Solution," below.) Preferred precursors are the metal nitrates which, upon firing, lose their nitrogen as nitrogen oxides. Spray drying is accomplished by conventional means, as described below.

The ceramics materials include those selected from the group of materials which are known to exhibit superconductivity at temperatures of liquid nitrogen or higher, such as those having unit cell formulas $Y Ba_x Cu_y O_z$ where x, y, and z, respectively, represent the amounts of barium, copper, and oxygen in the material relative to the amount of yttrium therein. In one embodiment x is about 2, y is about 3 and z is about 7; and in another embodiment x is about 0.67, y is about 0.83 and z is about 3.3. However, useful embodiments of this invention are also conveniently prepared from suitable precursors of such ceramic materials, which upon firing in an oxygen-containing atmosphere, will yield the metal oxide of the metals used in the ceramics. In other words, suitable precursors are those which, upon heating, lose components through volatilization so that the remaining components can combine to form the desired ceramic oxide material.

Firing of the compositions may be accomplished in conventional kilns. (See "Calcination," below.)

## The Metal Salt Solution

The above-identified L.M.A. metals have numerous salts that are soluble in the common solvents. These salts are well known and can be readily selected by reference to the literature. Salts should be selected with anions that burn off readily during calcining, leaving the respective L.M.A. oxides. We prefer the nitrates, in water solution.

## Spray Drying

We used a bench scale spray dryer, a Yamato Model GS 21 with a GF-31 attachment, made by Yamato USA, Inc., Northbrook, IL. In this unit the atomizer operated with compressed nitrogen, and air preheated to about 150°C was used in the drying chamber. The collecting pot, which operated on a cyclone principle, vented to the hood.

Commercial-scale spray dryers are recommended for larger operations. A variety is available, but all are based on two essential functions: (1) the feed is atomized; and (2) the atomized feed is dried in a stream of hot gas. Atomizers take various forms. The two most frequently found are the centrifugal-wheel - where the feed is flung as a fine spray from a rapidly whirling disk; and the pressure-nozzle atomizer (rather like a garden hose nozzle sprayer). The aim of course is to produce particles such that the largest will be completely dried during its retention time in the hot-gas chamber, where gas flow may be co- or counter- to particle flow. All of these considerations are well within the routine skill of the spray-drying art. (Cf. the article, Spray Drying, in Van Nostrand's Scientific Encyclopedia, 6th Ed., 2657-2658 [1983].)

## Calcination

Starting with the spray-dried L.M.A. salts, we calcine according to the following program:

1) The dried particles are placed in an alumina boat, which is then placed in an electric furnace, in flowing air.

2) The furnace is brought up to about 850°-1050°C, suitably 950°. The time required to bring the furnace up to temperature is not critical. At least a few minutes is however generally necessary, depending on structure and operation of the furnace.

3) The furnace is maintained at the temperature selected in 2) for about 4-8 hours, suitably about 6 hours.

4) Next, the furnace is gradually cooled over a period of time (i.e., linearly cooled). This step is important. We prefer to cool down to about room temperature to 250°C over 5-30 hours, suitably 8 hours.

(Comment: At this stage the calcined product - a powder - is superconducting. To facilitate the levitation test, it may be compressed into a wafer.)

The calcined product is now ready for compression, which is carried out using conventional compression techniques.

Products produced in accordance with this invention will become further apparent from the following non-limiting examples.

## EXAMPLE I

29.1 grams of yttrium nitrate ($Y(NO_3)_3.5H_2O$), 41.8 grams of barium nitrate ($Ba(NO_3)_2$) and 55.8 grams of copper nitrate ($Cu(NO_3)_2.2\frac{1}{2}H_2O$) were dissolved in 1200 milliliters of deionized water. The solution was spray dried by the procedure hereinafter described. The resulting aqua-blue powder (spherical particles) was placed in a furnace having an air atmosphere. The temperature was raised over a 12-hour period to 950°C, held at 950°C for 14 hours, and then lowered to room temperature (linearly cooled) over a 24-hour period. The black powder from the furnace was pressed at a pressure of about 10,000 psi into a wafer. The wafer was tested by levitation by the Levitation Test hereinafter described and was found to be superconductive.

## EXAMPLE II

The wafer tested in Example I was ground to a powder, reheated over a six-hour period in a furnace with flowing air to a temperature of 950°C for an additional six hours and then cooled to room temperature over a 12-hour period. It was compressed at 10,000 psi. The resulting pellet was dense (5.1 grams per cubic centimeter). The pellet levitated a magnet, showing the pellet had an electrical resistivity of essentially zero. $\Delta T_c$

Our superconducting ceramic product shows a

relatively narrow $\Delta T_c$, indicating a high degree of purity and homogeneity. By "Delta $T_c$" we mean the width of the resistivity curve as it leaves the zero resistivity line at some particular temperature, $T_c$, rises (generally sharply) with rising temperature, (indicating increasing resistivity and loss of superconductivity) and then levels off asymptotically at another particular temperature, indicating complete or substantially complete loss of superconductivity and entry of the ceramic into the world of normal resistance/conductivity.

## Extraneous Materials

We have mentioned that prior art processes conventionally enhance homogeneity by grinding the calcined superconductor, followed by recalcining. In some instances this sequence may be repeated several times. It is known that improved homogeneity in the general case enhances superconductivity. The problem here is that effective grinding inevitably and inherently introduces trace impurities into the ceramic, simply by impacting the ceramic between the balls and walls (or other grinding surfaces) of the grinding mill. It is known, for example, that silica or stainless steel balls in a ball mill lose significant mass over a period of use. This mass of course disappears into whatever was being milled. Mills that comminute by particle self-impact lose metal by wall-scouring, particularly in the area of stream entry.

Thus, the firing-grinding-refiring technique rapidly achieves a balance: improvement in homogeneity tends to be matched by contamination build-up that cancels part or all of the improvement.

Our process, by achieving ultimate homogeneity in the first place, avoids the grinding problem altogether. Our product can, of course, be subjected to the conventional firing-grinding-refiring cycle, (as we have shown in Example 2), but we can achieve superconductivity without it, as shown in Example 1. Our purest superconductors are obtained when no extraneous materials are introduced into the material at any stage. By "extraneous materials" we mean non-volatile materials introduced into the base metal solution e.g., potassium carbonate to precipitate Y, Ba, and Cu as carbonates. The term also includes contaminants (generally metals or metal oxides) introduced into the composition by grinding the L.M.A.D. composite. If the product is ground in a ball mill using quartz or silica balls, some of the impurity is silica. In the embodiment described in Example 1 we have no extraneous materials as herein defined.

## Levitation Test for Superconductivity

Various tests are available for the determination of superconductivity. One of these tests is conventional, simple, and is accepted in the art as definitive. We used this, the so-called levitation test, in our determinations, and we describe it below.

A circular wafer of the compound is prepared by calcining and compressing as described in Example 1. The wafer is about 1-inch in diameter and about 3/16-inch thick. It is placed in the center of a glass dish, and then liquid nitrogen (77° K) is poured into the dish.

The wafer bubbles a bit at first, as the nitrogen boils on contact, and as surface air is flushed from the wafer. In a few minutes gas evolution diminishes to nearly zero, and the wafer may be assumed to be chilled to approximately the temperature of liquid nitrogen. A chip of a rare earth magnet is now dropped gently over the wafer. If the magnet levitates, i.e., hovers in the air over the wafer, the wafer is superconducting. (Comment: Instances have been reported where the magnet sank; yet measurable superconductivity existed and was detectable by more sophisticated means. But a positive test, such as we achieved in our runs, shows certain superconductivity.)

The examples describe various embodiments of the invention. Other embodiments will be apparent to those skilled in the art from a consideration of the specification or practice of the invention disclosed herein. It is understood that modifications and variations may be practiced without departing from the spirit and scope of the novel concepts of this invention. It is further understood that the invention is confined to the particular formulations and examples herein illustrated, but it embraces such modified forms thereof as come within the scope of the following claims.

## Claims

1. A method of producing a superconducting ceramic solid consisting of metal oxides comprising the steps of:

(a) dissolving in a solvent which vaporizes without leaving substantial residue, soluble metal compound precursors of the ceramic solid which, upon firing in an oxygen-containing atmosphere yield the metal oxides;

(b) spray-drying the solution of metal compounds, thereby obtaining a composition which is an intimate blend of the metallic components; and

(c) firing the composition in an oxygen-containing environment to produce solid ceramic material.

2. The method of Claim 1 wherein the solid ceramic material is compressed.

3. The method of Claim 1 wherein the soluble metal compounds in (a) include

i) at least one metal compound from the rare earth group, including Sc and Y;

ii) at least one metal compound from the group Be, Mg, Ca, Sr, and Ba; and

iii) at least one metal compound from the group Cu, Ag, and Au.

4. The method of Claim 3 wherein the metal compounds are Y, Ba, and Cu nitrates in a Y:Ba:Cu atomic ratio of 1:2:3.

5. Metal oxide composition L.M.A.O. in which L is at least one metal of the rare earth group, including scandium and yttrium; M is at least one metal of the group Ba, Be, Mg, Ca, and Sr; A is at least one metal of the group Cu, Ag, and Au; and O is oxygen; characterized in that the composition is free of extraneous materials.

6. Composition according to Claim 5 in which L is Y, M is Ba, A is Cu, in a respective atomic ratio of 1:2:3.

7. Spheroidal particles consisting essentially of soluble L.M.A. salts, where L is at least one metal of the rare earth group including scandium and yttrium; M is at least one metal of the group Ba, Be, Mg, Ca, and Sr; and A is at least one metal of the group Cu, Ag, and Au.

8. Particles according to Claim 7 wherein L.M.A. is Y.Ba.Cu in an atomic ratio of 1:2:3.

9. Particles according to Claim 7, calcined to form a superconductor composition.

10. Composition according to Claim 9 wherein L.M.A. is Y.Ba.Cu in the atomic ratio of 1:2:3.

11. Particles according to Claim 7 wherein the L.M.A. salts are nitrates.

12. Process comprising spray-drying a solution of L.M.A. salts.

13. Process according to Claim 12 wherein the solution is L.M.A. nitrates in water.

14. Process according to Claim 13 wherein L is Y, M is Ba, and A is Cu in an atomic ratio of 1:2:3.

15. Process comprising calcining spray-dried L.M.A. salts at an initial temperature of about 850° - 1050° C to form L.M.A. oxides; maintaining said L.M.A. oxides at said temperature for about 4-8 hours; and linearly cooling the L.M.A. oxide product to a temperature in the range of about room temperature to 250° C over about 5-30 hours.

16. Process according to Claim 15 in which the L.M.A. oxide product is compressed.

17. Process according to Claim 15 in which L is Y, M is Ba, and A is Cu, in an atomic ratio of 1:2:3.

18. Process comprising

a) preparing an aqueous solution of yttrium nitrate, barium nitrate, and cupric nitrate in a Y:Ba:Cu atomic ratio of 1:2:3;

b) spray-drying the said solution to provide spheroidal particles of substantially uniform composition;

c) calcining the particles by raising the temperature to about 950° C over a period of about 12 hours;

d) maintaining the particles in c) at about 950° C for about 14 hours; and

e) lowering the temperature in d) gradually to about room temperature over a period of about 24 hours; thereby to prepare a superconductive composition.

Claims for the following Contracting State : ES

1. A method of producing a superconducting ceramic solid consisting of metal oxides comprising the steps of:

(a) dissolving in a solvent which vaporizes without leaving substantial residue, soluble metal compound precursors of the ceramic solid which, upon firing in an oxygen-containing atmosphere yield the metal oxides;

(b) spray-drying the solution of metal compounds, thereby obtaining a composition which is an intimate blend of the metallic components; and

(c) firing the composition in an oxygen-containing environment to produce solid ceramic material.

2. The method of Claim 1 wherein the solid ceramic material is compressed.

3. The method of Claim 1 wherein the soluble metal compounds in (a) include

i) at least one metal compound from the rare earth group, including Sc and Y;

ii) at least one metal compound from the group Be, Mg, Ca, Sr, and Ba; and

iii) at least one metal compound from the group Cu, Ag, and Au.

4. The method of Claim 3 wherein the metal compounds are Y, Ba, and Cu nitrates in a Y:Ba:Cu atomic ratio of 1:2:3.

5. Process comprising spray-drying a solution of L.M.A. salts.

6. Process according to Claim 5 wherein the solution is L.M.A. nitrates in water.

7. Process according to Claim 6 wherein L is Y, M is Ba, and A is Cu in an atomic ratio of 1:2:3.

8. Process comprising calcining spray-dried L.M.A. salts at an initial temperature of about 850° - 1050° C to form L.M.A. oxides; maintaining said L.M.A. oxides at said temperature for about 4-8 hours; and linearly cooling the L.M.A. oxide product to a temperature in the range of about room temperature to 250° C over about 5-30 hours.

9. Process according to Claim 8 in which the L.M.A. oxide product is compressed.

10. Process according to Claim 8 in which L is Y, M is Ba, and A is Cu, in an atomic ratio of 1:2:3.

11. Process comprising

a) preparing an aqueous solution of yttrium nitrate, barium nitrate, and cupric nitrate in a Y:Ba:Cu atomic ratio of 1:2:3;

b) spray-drying the said solution to provide spheroidal particles of substantially uniform composition;

c) calcining the particles by raising the temperature to about 950° C over a period of about 12 hours;

d) maintaining the particles in c) at about 950° C for about 14 hours; and

e) lowering the temperature in d) gradually to about room temperature over a period of about 24 hours; thereby to prepare a superconductive composition.

12. Metal oxide composition L.M.A.O. in which L is at least one metal of the rare earth group, including scandium and yttrium; M is at least one metal of the group Ba, Be, Mg, Ca, and Sr; A is at least one metal of the group Cu, Ag, and Au; and O is oxygen; characterized in that the composition is free of extraneous materials.

13. Composition according to Claim 12 in which L is Y, M is Ba, A is Cu, in a respective atomic ratio of 1:2:3.

14. Spheroidal particles consisting essentially of soluble L.M.A. salts, where L is at least one metal of the rare earth group including scandium and yttrium; M is at least one metal of the group Ba, Be, Mg, Ca, and Sr; and A is at least one metal of the group Cu, Ag, and Au.

15. Particles according to Claim 14 wherein L.M.A. is Y.Ba.Cu in an atomic ratio of 1:2:3.

16. Particles according to Claim 14, calcined to form a superconductor composition.

17. Composition according to Claim 16 wherein L.M.A. is Y.Ba.Cu in the atomic ratio of 1:2:3.

18. Particles according to Claim 14 wherein the L.M.A. salts are nitrates.